(19) **Europäisches Patentamt**
**European Patent Office**
**Office européen des brevets**

(11) **EP 4 278 193 B1**

(12) **FASCICULE DE BREVET EUROPEEN**

(45) Date de publication et mention
de la délivrance du brevet:
**20.08.2025  Bulletin 2025/34**

(21) Numéro de dépôt: **22700139.3**

(22) Date de dépôt: **11.01.2022**

(51) Classification Internationale des Brevets (IPC):
*G01P 15/12* (2006.01)   *B81B 7/00* (2006.01)
*B81B 3/00* (2006.01)   *G01L 1/18* (2006.01)
*H01L 23/367* (2006.01)

(52) Classification Coopérative des Brevets (CPC):
**G01P 15/123; B81B 3/0081; G01L 1/18;**
B81B 2201/0235; B81B 2201/0242;
B81B 2203/0118

(86) Numéro de dépôt international:
**PCT/EP2022/050393**

(87) Numéro de publication internationale:
**WO 2022/152670 (21.07.2022 Gazette 2022/29)**

(54) **DISPOSITIF DE DÉTECTION UTILISANT UNE TRANSDUCTION PIÉZORÉSISTIVE**

DETEKTIONSVORRICHTUNG MIT PIEZORESISTIVER TRANSDUKTION

DETECTION DEVICE USING PIEZORESISTIVE TRANSDUCTION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.01.2021  FR 2100249**

(43) Date de publication de la demande:
**22.11.2023  Bulletin 2023/47**

(73) Titulaire: **Commissariat à l'Energie Atomique et
aux Energies
Alternatives
75015 Paris (FR)**

(72) Inventeurs:
• **JOURDAN, Guillaume
38054 GRENOBLE Cedex 09 (FR)**
• **ROBERT, Philippe
38054 GRENOBLE Cedex 09 (FR)**

(74) Mandataire: **Hautier IP
20, rue de la Liberté
06000 Nice (FR)**

(56) Documents cités:
**EP-A1- 3 339 242      US-A1- 2014 076 024
US-A1- 2017 113 918**

## Description

DOMAINE TECHNIQUE DE L'INVENTION

La présente invention concerne le domaine des dispositifs de détection piézorésisitifs.

De manière générale, ce type de dispositif fait appel à la capacité de transduction de matériaux piézorésistifs. Il peut s'agir de capteurs inertiels de type accéléromètre, gyroscope ou gyromètre à un axe ou multiaxes, ou encore des capteurs de pression, des magnétomètres ou des microphones. Cela concerne les capteurs sous forme de dispositifs micro-électroniques. Par dispositif micro-électronique, on entend tout type de dispositif réalisé avec les moyens de la microélectronique. Ces dispositifs englobent des dispositifs micromécaniques ou électromécaniques (MEMS, NEMS...).

ETAT DE LA TECHNIQUE

Les nanojauges piézorésistives sont utilisées dans de nombreux capteurs MEMS comme transducteurs entre une grandeur mécanique à mesurer (pression, accélération, rotation, ...) et une grandeur électrique utilisable en électronique (tension, courant ou résistance). Ce type de transduction utilise la piézorésistivité d'une jauge pour convertir une contrainte ou une déformation mécanique en variation de résistance électrique.

Le document US 2017/113918 A1 divulgue une solution complexe de détection à transduction de type différentielle. Le document EP 3 339 242 A1 divulgue lui un système de détection à bande-passante accordable.

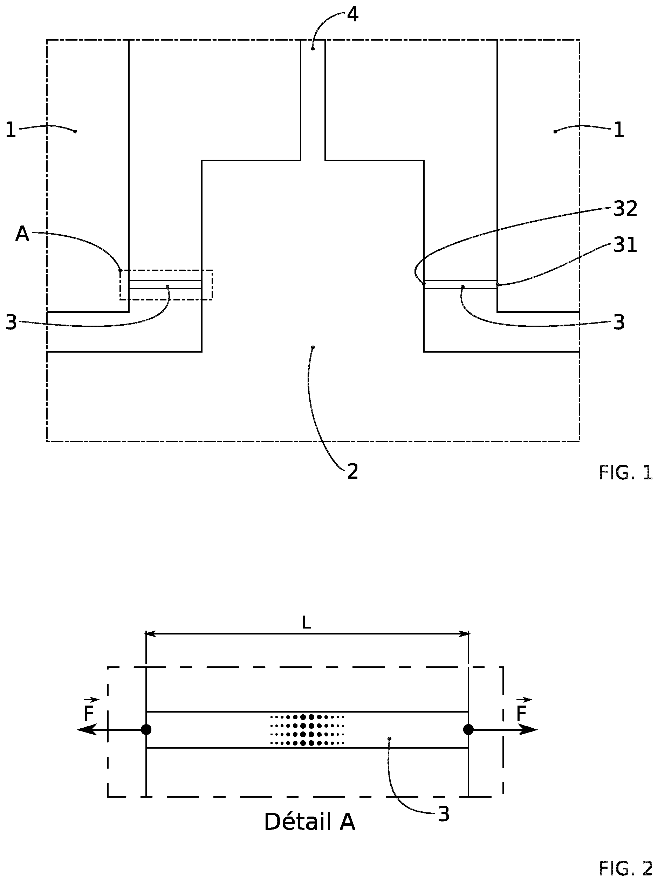

La figure 1 présente un exemple de dispositif de détection connu, ici un accéléromètre, dans lequel une masse 2 est montée mobile relativement à un substrat 1, par exemple à base de silicium. Dans le cas d'espèce, on cherche à mesurer un déplacement de la masse mobile 2 en rotation dans le plan du substrat 1, c'est-à-dire une rotation autour d'un axe suivant une direction perpendiculaire à ce plan. Dans cet exemple, la masse 2 est mobile autour de cette direction de rotation grâce à au moins une charnière 4 qui relie, avec une liberté de mouvement en rotation selon la direction perpendiculaire au plan, la masse 2 à une zone d'ancrage intégrée au substrat.

Le mouvement de rotation peut être traduit en une valeur électrique par l'intermédiaire d'une jauge de contrainte 3 utilisant la capacité d'un matériau piézorésistif de convertir une grandeur mécanique en une grandeur électrique, et, de manière primaire, en variation de résistance électrique. Dans le cas représenté, deux jauges 3 travaillent en opposition (lorsque l'une est en traction, l'autre est en compression) et présentent chacune la forme d'une poutre dont une première extrémité 31 est ancrée sur une zone d'encastrement intégrée au substrat 1 et dont l'autre extrémité 32 est ancrée sur la masse mobile 2. La poutre de la jauge 3 présente généralement une dimension en longueur dirigée suivant une direction de détection.

On comprend qu'un mouvement de la masse 2 dans le plan va produire une déformation des jauges 3, ici essentiellement en traction/compression, ce qui va induire une variation de résistance électrique du matériau piézorésistif de chaque jauge 3, variation de résistance électrique qui peut être mesurée par un circuit de mesure. Ce dernier peut par exemple détecter une variation du rapport entre la tension aux bornes de la jauge et le courant qui la traverse au cours du temps, de sorte à évaluer la variation de résistance. Un pont de Wheatstone peut également être mis en œuvre pour mesurer un déséquilibre proportionnel à la variation de résistance.

La partie électronique de mesure comprend typiquement un générateur de courant de polarisation et un circuit de mesure des variations de tension, qui révèlent des variations de résistivité électrique dans la jauge, elles-mêmes fonctions de la déformation de la jauge. On réalise ainsi une transduction de déformations mécaniques (ou d'efforts) en signal électrique.

D'une manière générale, on peut traduire la mesure de la façon suivante dans une équation liant la tension de mesure (V) et le courant de polarisation ($I_0$) :

$$V = \Delta R I_0 = R I_0 \pi \varepsilon \ car \ \frac{\Delta R}{R} = \pi \varepsilon$$

- V = la tension de mesure
- $\pi$ = coefficient de piézorésistivité
- R = résistance électrique
- $\varepsilon$ = déformation qui est proportionnelle :

  ○ au déplacement de la pièce mobile $\varepsilon = \frac{x}{L}$ où L est la longueur de la poutre de la jauge ;
  ○ à la force appliquée sur les extrémités dans la direction de la longueur $\varepsilon = \frac{F}{SE}$ où S est la section de la jauge et E le module d'Young

Le rapport signal à bruit (SNR) du capteur final (en dehors du bruit en 1/f ; par exemple, cette situation se rencontre si on s'intéresse au SNR au voisinage d'une fréquence de fonctionnement différente de 0, dans une zone ou le bruit en 1/f est négligeable par rapport aux autres bruits (bruit de Johnson, bruit du circuit électronique,...) dépend en partie du courant de polarisation, comme l'illustre l'équation suivante :

$$SNR = \frac{R I_0 \, \pi \varepsilon}{\sqrt{4 k_B \, T R \, B + S_{elec}}} \ \alpha \ I_0$$

Avec B : la bande passante de mesure, T la température, $k_B$ la constante de Boltzmann, $S_{elec}$ bruit de l'électronique ; le signe $\alpha$ signifie ici une relation de proportionnalité à $I_0$.

Il est donc naturel de chercher à augmenter le courant de polarisation dans l'objectif d'améliorer le dispositif de détection.

Malgré tout, l'augmentation du courant de polarisation est limitée à cause de l'échauffement qu'induit ce courant à l'intérieur de la jauge. En particulier, l'auto échauffement de la jauge obéit à l'équation suivante :

$$\Delta T_{max} = \frac{R_{th}}{8} P \; \alpha \; I_0^2$$

Avec $R_{th} = \frac{L}{kS}$ la résistance thermique, $\kappa$ la conductivité thermique du matériau qui compose la jauge ; le signe $\alpha$ signifie ici une relation de proportionnalité à $I_0^2$.

Il en ressort que l'échauffement de la jauge est une fonction quadratique du courant de polarisation. Dans la pratique, pour une jauge en silicium dopé, l'échauffement peut être comme suit :

- $\kappa \approx 50 \; S.I$
- $R_{th} = 1,5 \; K. \; \mu W^{-1}$
- $R \approx 2000 \; \Omega$

Cela produit un auto échauffement comme suit, selon le courant circulant dans la jauge :

P = 20 $\mu$W (I = 100 $\mu$A) : de l'ordre de 4 K,
P = 320 $\mu$W (I = 400 $\mu$A) : de l'ordre de 64 K,
P = 1280 $\mu$W (I = 800 $\mu$A) : de l'ordre de 256 K.

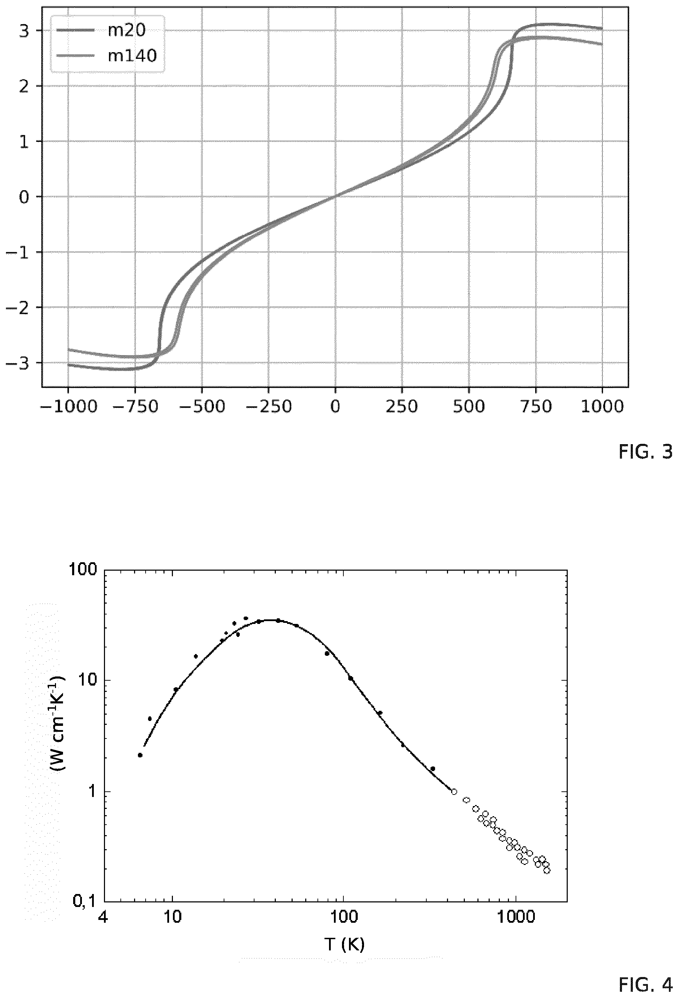

Si on suppose que les paramètres électriques et de conductivité thermique restent constants. En pratique, l'échauffement peut s'emballer (figure 3) en raison d'une baisse de la conductivité thermique avec la température (figure 4).

La figure 2 traduit de manière schématique les répercussions néfastes d'une température trop élevée à l'intérieur de la jauge. En effet, on y a schématisé un excès thermique, constaté surtout au milieu de la longueur de la jauge (notée L dans les formules), ici sous forme d'une poutre faite d'un nanofil de silicium. Les trois exemples de puissance thermique fournis ci-dessus reflètent par ailleurs le caractère quadratique de l'accroissement de la température avec le courant de polarisation.

L'échauffement peut s'avérer tel qu'il dégrade, éventuellement de façon irréversible, le fonctionnement de la jauge. La figure 3 montre, à deux niveaux différents de température ambiante (respectivement 20°C, et 140°C en trait plus clair) de fonctionnement de la jauge, l'évolution de la tension de mesure (en volts) relativement au courant (en $\mu$A). Ces deux courbes procurent le même enseignement. Lorsque la valeur absolue du courant ne dépasse pas un premier seuil de l'ordre de 400 $\mu$A, la fonction obtenue est sensiblement linéaire. Dans ce contexte, le fonctionnement de la jauge peut être considéré comme fiable. Passé ce seuil, la courbe n'est pas linéaire et traduit une chute de la conductivité électrique. Après un deuxième seuil (ici autour de 750/800 $\mu$A), la tension connaît un plateau qui traduit une forte dégradation du fonctionnement de la jauge, que l'on peut associer au passage d'un comportement extrinsèque à un comportement intrinsèque du semiconducteur. A de tels niveaux de courant, les effets de la température peuvent détruire la jauge ou pour le moins affecter ses qualités de manière irréversible.

La figure 4 est une représentation de l'évolution de la conductivité thermique (en W.cm$^{-1}$.K$^{-1}$) en fonction de la température en degrés Kelvin. La diminution de la conductivité thermique avec la température tend à amplifier l'auto échauffement, car la puissance dissipée est de plus en plus contenue dans le nanofil.

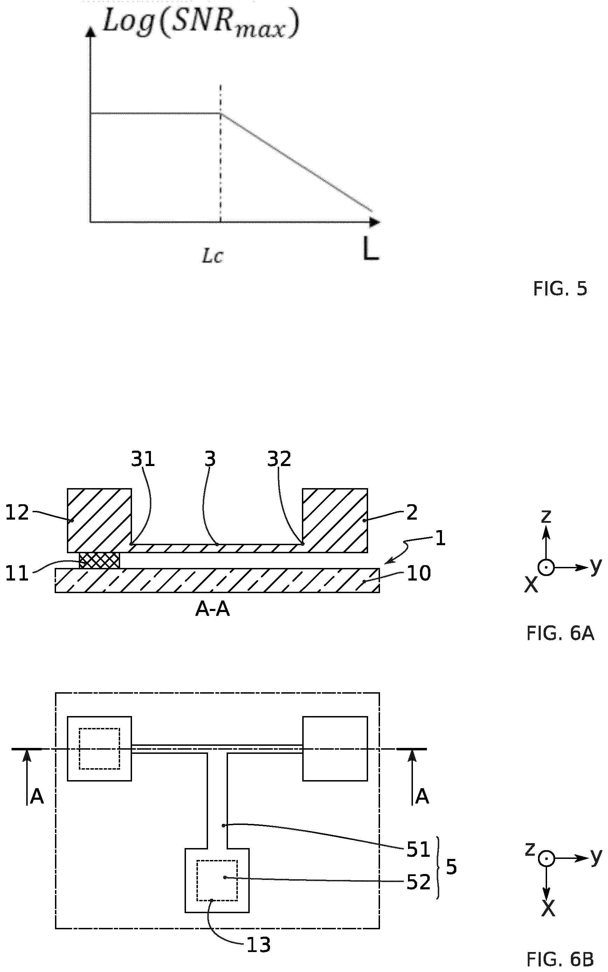

Il ressort enfin de la figure 5, purement schématique, qu'une solution potentielle consistant à augmenter la longueur de la jauge n'est en fait pas efficace si on s'intéresse au rapport signal sur bruit pour le signal de déplacement x de la masse 2. La résistance R mentionnée dans la première formule ci-dessus augmente de façon linéaire avec la longueur de poutre piézorésistive, mais l'augmentation de la longueur a un impact négatif, inversement proportionnel, sur la déformation : $\varepsilon = \frac{x}{L}$ .

Cette compensation est révélée par la partie horizontale de la fonction logarithmique de la figure 5. De plus, lorsque la longueur augmente trop (ici au-delà du seuil $L_c$), cette fonction se dégrade même en raison de la prédominance du bruit thermique de la résistance.

Il convient donc de rester dans une gamme de températures, et par conséquent une gamme de courants de polarisation, qui soit acceptable, pour un fonctionnement fiable de l'élément piézorésistif de la jauge.

Il existe donc un besoin pour proposer des dispositifs de détection qui optimisent le fonctionnement de l'élément piézorésistif, et notamment qui optimise le courant de polarisation.

Les autres objets, caractéristiques et avantages de la présente invention apparaîtront à l'examen de la description suivante et des dessins d'accompagnement. Il est entendu que d'autres avantages peuvent être incorporés.

RESUME DE L'INVENTION

Pour atteindre cet objectif, selon un mode de réalisation, on prévoit un dispositif de détection à transduction comprenant un substrat, au moins une masse mobile relativement au substrat et une jauge de contrainte suspendue dotée d'un élément piézorésistif qui comprend un premier ancrage relativement à une portion d'ancrage et un deuxième ancrage, différent du premier ancrage, relativement à la masse mobile.

De manière avantageuse, le dispositif comprend au moins un élément dissipateur thermique raccordé de manière thermiquement conductrice d'une part à une portion de raccordement de l'élément piézorésistif située en dehors des ancrages, et d'autre part à une partie du dispositif, dite partie d'évacuation thermique, autre que l'élément piézorésistif.

Suivant un aspect, la partie du dispositif autre que l'élément piézorésistif est le substrat. Alternativement, il peut s'agir de la masse mobile. Il peut aussi s'agir de la portion d'ancrage.

On forme ainsi un dispositif qui peut, à échauffement thermique équivalent de l'élément piézorésistif, supporter des courants de polarisation plus élevés, étant rappelé que l'élévation du courant de polarisation est favorable à l'accroissement du rapport signal/bruit.

Alors que l'élément piézorésistif est habituellement considéré comme un organe mécanique individualisé impliquant de le traiter de manière isolée du reste du dispositif de détection, la présente invention lui associe au moins un élément de dissipation d'énergie thermique.

Avantageusement, l'élément de dissipation d'énergie thermique est configuré pour ne pas perturber, ou de façon fort limitée et pour le moins pas rédhibitoire, le comportement mécanique et/ou électrique de l'élément piézorésistif. Ainsi, on pourra concevoir le ou les éléments dissipateurs de sorte à minimiser leur raideur dans la direction de détection, qui peut, typiquement, être la direction longitudinale d'une poutre faite d'un matériau piézorésistif. On pourra par ailleurs réduire au maximum la résistance électrique additionnelle engendrée par l'élément de dissipation d'énergie thermique.

La jauge ou élément piézorésistif pourra par exemple être suspendue au-dessus d'une face du substrat. Éventuellement, au moins un élément dissipateur thermique est réalisé dans un matériau différent de celui de l'élément piézorésistif. L'élément dissipateur thermique peut se situer au-dessus de l'élément piézorésistif.

Ce dissipateur thermique peut lui-même être connecté au substrat. Ce raccordement assure pour le moins une conduction thermique de sorte à évacuer de la chaleur vers le substrat. Cela peut servir au maintien mécanique de sa structure.

La notion de résistance thermique de l'élément dissipatif sert à former une liaison thermique entre jauge et substrat par cette connexion ; cette résistance thermique est de préférence inférieure à celle de la jauge, avantageusement au moins cinq fois inférieure.

Le dispositif peut être intégré dans un appareil comprenant une fonction exploitant une détection de valeurs de mouvement (en cinématique, cinétique ou dynamique) ; il peut aussi s'agir de capteurs de pression, de magnétomètres ou de microphones.

## BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La figure 1 représente un exemple de structure connue d'un système de détection sous forme d'accéléromètre.

La figure 2 représente une jauge de détection extraite du système de la figure précédente, et schématise une élévation de la température localisée au centre de la jauge.

La figure 3 représente une courbe d'évolution de la tension de mesure relativement au courant de polarisation, à deux niveaux de température ambiante de fonctionnement de la jauge, à savoir 20°C et 140°C.

La figure 4 illustre l'évolution de la conductivité thermique d'un élément piézorésistif à base de silicium en fonction de sa température.

La figure 5 montre la dépendance du rapport signal/bruit maximal $SNR_{max}$ d'une jauge à élément piézorésistif en fonction de la longueur de ce dernier.

Les figures 6A et 6B représentent respectivement une vue en coupe et une vue de dessus d'un dispositif selon un premier mode de réalisation.

Les figures 7A et 7B représentent respectivement une vue en coupe et une vue de dessus d'un dispositif selon un deuxième mode de réalisation.

Les figures 8A et 8B représentent respectivement une vue en coupe et une vue de dessus d'un dispositif selon un troisième mode de réalisation.

Les figures 9A et 9B représentent respectivement une vue en coupe et une vue de dessus d'un dispositif selon un quatrième mode de réalisation.

Les figures 10A et 10B représentent respectivement une vue en coupe et une vue de dessus d'un dispositif selon un cinquième mode de réalisation.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

## DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :
Suivant une option, la partie d'évacuation thermique est le substrat, ou la masse mobile ou la portion d'ancrage du premier ancrage.

Dans un cas, la portion d'ancrage est une portion du substrat 1 ; ainsi, la partie 31 est raccordée, de préférence fixement dans ce cas, relativement au substrat 1.

Selon un exemple, l'élément piézorésistif 3 comporte une première raideur, suivant une direction de détection (Y) selon laquelle l'élément piézorésistif 3 est sollicité en traction ou en compression, et selon laquelle l'élément dissipateur thermique 5 présente, suivant la direction de détection, une deuxième raideur qui est strictement inférieure à la première raideur.

Suivant une possibilité, la deuxième raideur est au moins cinq fois plus faible que la première raideur.

Suivant une autre possibilité, l'élément dissipateur thermique (5) présente, au niveau de la portion de raccordement, une direction principale oblique relativement à une dimension longue de l'élément piézorésistif (3). L'élément dissipateur thermique 5 forme ainsi, au niveau de la portion de raccordement, un changement de direction relativement à une dimension longue de l'élément piézorésistif 3.

Selon un exemple, l'élément dissipateur thermique 5 comprend une partie suspendue s'étendant depuis la portion de raccordement.

Éventuellement, l'élément dissipateur thermique 5 comprend un bras 51.

Suivant une possibilité, le bras 51 présente une dimension longitudinale dirigée obliquement relativement à la direction de détection.

Suivant une possibilité, la dimension longitudinale est perpendiculaire à la direction de détection.

Dans un mode de réalisation, le bras 51 présente un rapport de forme de la dimension longitudinale et sa dimension suivant la direction de détection d'au moins 5.

Dans un mode de réalisation, le bras 51 présente, suivant une direction perpendiculaire à sa dimension longitudinale et à la direction de détection, une dimension en hauteur supérieure à une dimension en hauteur de l'élément piézorésistif 3.

Selon un exemple, la portion de raccordement est située au milieu d'une dimension longue de l'élément piézorésistif 3.

Selon un exemple, l'élément dissipateur thermique 5 présente une conductance thermique supérieure ou égale à celle de l'élément piézorésistif 3, et de préférence au moins cinq fois, voire dix fois supérieure.

Selon un exemple, l'élément dissipateur thermique 5 présente au moins un degré de liberté de mouvement relativement à la partie d'évacuation thermique, de préférence selon la direction de déformation de la jauge.

Eventuellement, l'élément dissipateur thermique 5 comporte un organe ressort 54.

Suivant une possibilité, en particulier hors basses fréquences, par exemple pour un gyromètre, l'élément dissipateur thermique 5 comporte une fréquence de résonance strictement supérieure à celle d'un ensemble formée par la jauge et la masse mobile 2, et de préférence au moins cinq, voire dix fois supérieure. Cette fréquence de résonance peut s'obtenir sur la structure sans l'élément dissipateur, avec les deux portions de jauges qui n'en forment qu'une seule.

Selon un exemple, l'élément piézorésistif 3 est une poutre.

Dans un mode de réalisation, le dispositif comprend plusieurs éléments dissipateurs thermiques 5.

Suivant un aspect, les éléments dissipateurs thermiques 5 sont chacun raccordés à une portion de raccordement de l'élément piézorésistif 3, les portions de raccordement découpant l'élément piézorésistif 3 en tronçons de longueur identique suivant la dimension longue de l'élément piézorésistif.

Suivant une possibilité, les éléments dissipateurs thermiques 5 sont chacun raccordés à une portion de raccordement de l'élément piézorésistif 3, les portions de raccordement étant situées de manière symétrique autour du milieu de la dimension longue de l'élément piézorésistif 3. Ils peuvent aussi être situés de part et d'autre de l'élément piézorésistif, de manière alternée.

De préférence, chaque dissipateur 5 est raccordé de manière thermiquement conductrice au substrat 1.

Le dissipateur thermique peut être réalisé dans un matériau isolant électrique ou peu conducteur (Silicium non dopé contrairement à la jauge) : dans la présente invention, il n'a pas vocation à conduire un courant électrique, même si cela n'est pas interdit pour d'autres raisons, mais principalement à conduire l'énergie thermique.

Si le matériau est conducteur, une mesure de la tension au point de raccordement peut avantageusement être réalisée pour contrôler l'état de déformation de la jauge.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant, soit directement à son contact, soit en étant séparée d'elle par un film, ou encore une autre couche ou un autre élément. En particulier, la jauge de contrainte est suspendue généralement au-dessus d'une face du substrat, ce qui implique un espace, généralement rempli d'air, intermédiaire entre ladite jauge et cette face du substrat. Une couche peut par ailleurs être composée de plusieurs sous-couches d'un même matériau ou de matériaux différents.

Il est précisé que dans le cadre de la présente invention, l'épaisseur d'une couche ou du substrat se mesure selon une direction perpendiculaire à la surface selon laquelle cette couche ou ce substrat présente son extension maximale. Si une couche n'est pas totalement plane, notamment parce qu'elle présente des défauts qui sont susceptibles d'être en relief sur la face exposée de ladite couche, l'épaisseur s'entend de la dimension de cette couche en dehors de ses défauts.

Certaines parties du dispositif de l'invention peuvent avoir une fonction électrique. Certaines sont employées pour des propriétés de conduction électrique et on entend comme ayant une nature électriquement conductrice, des éléments formés d'au moins un matériau ayant une conductivité électrique suffisante, dans l'application, pour réaliser la fonction souhaitée.

Certaines parties du dispositif de l'invention peuvent avoir une fonction thermique. Certaines sont employées pour des propriétés de conduction thermique et on entend comme ayant une nature thermiquement conductrice, des éléments formés d'au moins un matériau ayant une conductivité thermique suffisante, dans l'application, pour réaliser la fonction souhaitée ; en particulier pour limiter la température d'un autre élément en dissipant de l'énergie thermique de cet élément.

On entend par un substrat, un élément, une couche ou autre « à base » d'un matériau M, un substrat, un élément, une couche comprenant ce matériau M uniquement ou ce matériau M et éventuellement d'autres matériaux, par exemple des éléments d'alliage, des impuretés ou des éléments dopants. Le cas échéant, le matériau M peut présenter différentes stoechiométries.

Hormis pour la présence d'au moins un élément dissipateur thermique détaillé ci-après, la description donnée de la figure 1 est applicable à la réalisation de l'invention. Notamment, la masse mobile 2 est par la suite présentée de manière schématique, étant entendu qu'elle présente elle-même typiquement une liaison mécanique autre que l'élément piézorésistif 3, par exemple sous forme d'une articulation la suspendant au-dessus du substrat, comme c'était le cas de la partie 4 référencée sur la figure 1.

La jauge présente, ou consiste en, un élément piézorésistif 3. Ce dernier peut notamment être réalisé à partir de silicium, préférentiellement dopé afin de diminuer sa résistivité. D'autres matériaux semi-conducteurs, et notamment du germanium, de préférence également dopé, sont possibles. Il peut aussi s'agir de métaux comme du nickel ou du platine ; ou encore d'un alliage métal/silicium, tel qu'un siliciure d'aluminium.

En pratique, on donne ci-après des exemples de dimensions typiques de nanojauges mises en œuvre pour réaliser des capteurs :

- longueur L de quelques micromètres à plusieurs dizaines de micromètres, et par exemple entre 5 $\mu$m et 100 $\mu$m;
- section S, par exemple carrée, de quelques dizaines de nanomètres à plusieurs micromètres, et par exemple entre 5 nm et 20 $\mu$m ;
- pour du silicium, dopage bore (p), phosphore (n) variables de 1016 à 8.1019cm-3.

En référence aux courbes des figures 3 et 4, la jauge est en silicium dopé p à 5x10$^{19}$ cm$^{-3}$ de dimensions 5 $\mu$m x 250 nm x 250 nm. Le courant de polarisation peut varier de quelques dizaines à plusieurs centaines de $\mu$A, avec une résistance électrique de l'élément 3 de R ≈ 2000 $\Omega$, avec un courant maximal de 400 $\mu$A.

Cet élément piézorésistif 3 peut être conforme à une jauge piézorésistive classique. En ce qui concerne le circuit de mesure, on pourra également mettre en œuvre des moyens conventionnels.

Comme dans le cas de la jauge de l'état de la technique présenté à la figure 1, l'élément piézorésistif 3 peut s'étendre intégralement entre deux ancrages 31,32, ici aux deux extrémités de l'élément piézorésistif 3. Lorsque le dispositif est en fonctionnement, le courant de polarisation parcourt typiquement l'intégralité de la jauge, depuis un premier ancrage 31 jusqu'à un deuxième ancrage 32. L'élément piézorésistif 3 est ici de section carrée, mais d'autres sections notamment polygonales, et en particulier rectangulaires, sont possibles. Une section circulaire est aussi envisageable. Néanmoins, d'autres formes géométriques sont possibles, notamment une membrane.

Suivant une possibilité, l'élément 3 est une partie continue entre les ancrages 31, 32 et le ou les éléments de dissipation thermique 5 qui sont alors raccordés sur ce tronçon unique de matière de jauge, par exemple en superposition, suivant la direction Z ou en juxtaposition suivant la direction X. Suivant une autre possibilité, l'élément 3 est discontinu et est réalisé en plusieurs tronçons découpés par le ou les éléments de dissipation thermique 5. Dans ce cas, la portion de raccordement de chaque élément 5 est une bordure d'un tronçon de l'élément 3.

Dans un mode de réalisation, l'élément 3 est une poutre, de préférence de section transversale carrée, dont la dimension longue L est dirigée suivant la direction de détection correspondant à celle des flèches F de la figure 2.

L'élément piézorésistif 3 surplombe une face du substrat 1. Ce dernier peut être fait de silicium, éventuellement avec une couche superficielle d'oxyde, natif ou non, définissant cette face.

Dans un mode de réalisation, la mise en suspension de l'élément 3 piézorésistif est produite de la façon suivante : l'élément 3 est défini à la surface du substrat, par exemple dans une couche de silicium monocristallin (par exemple la couche supérieure d'un substrat du type silicium sur isolant) ; puis la couche sous-jacente (par exemple le matériau isolant d'un substrat du type silicium sur isolant), est attaquée par gravure, par exemple chimique avec de l'acide fluorhydrique, pour produire la libération de l'élément 3. Cette gravure est limitée latéralement de sorte à préserver au moins un ancrage 31 de l'élément 3 relativement au substrat 1. La face du substrat 1 peut être formée par la surface d'une portion résiduelle de la couche ayant fait l'objet de l'attaque par gravure, typiquement un matériau isolant, comme de l'oxyde de silicium. Elle peut aussi être formée par la surface d'une couche initialement située sous la couche d'isolant ou encore par la surface d'une couche rapportée ensuite, ou encore par la surface d'une couche d'oxyde formée naturellement après la libération de l'élément 3.

En se référant à la figure 6A, on a représenté, en coupe suivant les lignes A-A de la figure 6B, un premier mode de réalisation du dispositif de détection selon l'invention. La jauge s'y présente sous la forme d'un élément piézorésistif 3 pourvu de la forme géométrique d'une poutre dont la dimension longue s'étend suivant la direction Y du plan XY qui peut être celui de la face du substrat 1. L'axe Y correspond par ailleurs à la direction de sollicitation mécanique de l'élément 3 pour la détection. La direction Z montrée à la figure 6B correspond à la hauteur des organes représentés, et s'étend de préférence perpendiculairement à la face du substrat 1.

L'élément piézorésistif 3 comprend un premier ancrage 31 ici positionné à une première extrémité. Le premier ancrage 31 le relie dans cet exemple au substrat 1. Avantageusement, il s'agit d'un encastrement complet. On entend par encastrement complet de deux pièces que ces deux pièces n'ont aucun degré de liberté de mouvement l'une relativement à l'autre. L'élément piézorésistif 3 peut être d'un seul tenant avec la masse mobile 2 et/ou le plot d'ancrage 12.

Suivant un mode de réalisation non représenté, l'élément piézorésistif 3 n'est pas ancré sur le substrat 1. En particulier, le premier ancrage 31 peut servir de portion de raccordement à un autre élément, une portion d'ancrage, telle une deuxième masse mobile relativement au substrat 1. Le premier ancrage 31 n'est donc pas toujours un point fixe relativement au substrat.

Pour mettre en suspension l'élément 3 au-dessus du substrat, ce dernier comprend dans cet exemple un plot d'ancrage 12 servant de portion d'ancrage et faisant saillie au-delà d'une couche de base 10 du substrat, une partie d'oxyde d'ancrage 11 reliant, dans cette illustration, la couche de base 10 et le plot d'ancrage 12. Par exemple, la partie 11 peut-être une zone résiduelle d'une couche d'oxyde ayant servi à la fabrication et ayant fait l'objet d'une gravure partielle. Dans ces conditions, l'épaisseur de la partie 11 correspond à la hauteur de suspension de l'élément 3.

Comme indiqué par ailleurs, l'ancrage 31 peut se faire sur une autre partie que le substrat 1, telle une masse mobile. Dans ce cas, le plot 12, ou une autre forme de portion d'ancrage reliée à l'ancrage 31, est lui-même une partie présentant une mobilité relative avec le substrat 1. Dans le cas où les deux ancrages 31 et 32 sont ainsi mobiles relativement au substrat 1, la jauge peut avoir pour fonction d'évaluer le mouvement relatif des deux masses que les ancrages relient. Les masses 2 et 12 peuvent donc être toutes les deux mobiles selon l'axe y. Elles sont chacune reliées au substrat par un chemin mécanique propre (sans compter la jauge 3) qui leur confèrent une raideur $k_2$ et $k_{12}$ par rapport au substrat. La raideur $k_5$ de l'élément 5 par rapport à ce même substrat est alors de préférence faible devant au moins l'une des deux raideurs $k_2$ et $k_{12}$ pour que la fonction mécanique de la jauge soit bonne.

D'une manière générale, la partie 11 sert avantageusement d'isolant électrique entre l'élément 3, le plot 12 et la zone, qui est par exemple une partie de la face du substrat 1, à laquelle l'élément 3 est relié par cette extrémité 31. La couche d'oxyde indiquée précédemment assure cette fonction. De préférence, cette isolation électrique ne forme pas pour autant une isolation thermique.

Dans les modes de réalisation illustrés, un deuxième ancrage 32 raccorde l'élément 3 à une masse mobile 2. Cette dernière est l'organe dont on va chercher à évaluer le comportement en termes de mouvement et/ou de sollicitation mécanique. En particulier, la masse mobile 2 peut servir de partie déplaçable suivant au moins un degré de liberté, le mouvement suivant ce degré de liberté étant ensuite détecté par la jauge, du fait de la mise en traction ou en compression de l'élément piézorésistif 3. Le deuxième ancrage 32 est également de préférence un encastrement complet. Éventuellement, la masse mobile 2 peut être réalisée dans la même phase de fabrication que l'élément piézorésistif 3 et peut être issue d'une même couche de matériau mis en forme, en particulier par gravure.

De façon caractéristique, le dispositif de détection comporte en outre au moins un élément dissipateur thermique 5. Ce dernier est relié à l'élément piézorésistif 3 de sorte à assurer une conduction thermique entre ces deux éléments, cette conduction thermique étant configurée pour évacuer une partie de l'échauffement appliqué à l'élément piézorésistif 3 durant son fonctionnement, en particulier du fait du courant de polarisation. Il peut aussi être relié, avec conduction thermique, à un réservoir thermique (une masse permettant d'absorber des calories) tel le substrat.

Suivant une première possibilité, l'élément dissipateur thermique 5 est dans un matériau différent de celui de l'élément piézorésistif. On pourra par exemple utiliser des matériaux présentant une conductivité thermique supérieure. Dans ce mode de réalisation, on peut par ailleurs sélectionner un matériau d'élément dissipateur thermique 5 qui présente une résistivité électrique plus importante que celle de l'élément piézoélectrique 3, et de préférence qui constitue un diélectrique dans cette application ; cela permet de ne pas impacter le fonctionnement de la mesure électrique. Par exemple, le rapport des résistivités peut être supérieur à 100. On peut par exemple réaliser l'élément dissipateur thermique 5 avec une couche de diamant qui présente une excellente conductivité thermique et qui se comporte comme un isolant électrique. Dans ce cas, on peut envisager un report de matériaux (diamant sur le substrat) sur lequel est fabriqué la au moins une jauge.

Suivant une autre option, il s'agit du même matériau. Ainsi, par exemple, l'élément dissipateur thermique 5 peut être réalisé en silicium ou en d'autres matériaux semi-conducteurs. D'une manière générale, on s'arrange cependant pour que le ou les éléments dissipateurs thermiques 5 soient isolés électriquement de la jauge. Il faut en effet de préférence une discontinuité électrique ou une résistance au moins cinq fois supérieure entre la sortie de l'élément 5 et les ancrages 31 et 32 sans passer par les jauges elles-mêmes ; plus précisément, il est possible que l'impédance des boucles électriques passant par l'élément 5 et l'ancrage 31 et/ou par l'élément 5 et l'ancrage 32 soit supérieure d'un facteur au moins de cinq par rapport aux jauges seules.

Si un élément dissipateur 5 est en un matériau présentant une conductivité électrique non négligeable, une interface électriquement isolante peut être formée au niveau de la portion de raccordement.

De manière non limitative, le ou les éléments dissipateurs thermiques sont réalisés d'un seul tenant avec l'élément piézorésistif 3. En particulier, ces deux parties peuvent être issues d'une matière mise en forme de la manière appropriée. Par exemple, l'élément dissipateur thermique 5 peut être produit lors de la phase de libération de l'élément piézorésistif 3.

Un élément dissipateur thermique 5 est relié à l'une de ses extrémités à une portion de raccordement de l'élément piézorésistif 3. L'élément 5 est par ailleurs de préférence suspendu depuis la portion de raccordement de sorte à ne pas altérer, ou à peu altérer, la liberté de déformation de l'élément piézorésistif 3 suivant la direction de détection Y.

L'autre extrémité de l'élément dissipateur thermique 5 est ancrée relativement à une partie du dispositif autre que l'élément piézorésistif 3, ou encore est reliée à cette partie par une liaison cinématique autorisant au moins un degré de liberté, ce qui permet d'opposer peu de résistance à la déformation de la jauge.

Dans les modes de réalisation présentés aux illustrations, la partie de dispositif autre que l'élément piézorésistif 3 est le substrat 1. Cependant, d'autres dispositions sont possibles, par exemple en raccordant l'élément dissipateur 5 à un autre organe du dispositif ; il peut en particulier s'agir de la masse mobile 2 ou du plot 12 (ou autre portion d'ancrage de l'ancrage 31). Ainsi, la partie du dispositif servant à l'évacuation des calories générées par l'élément piézorésistif 3 peut en elle-même être une partie présentant une mobilité relativement au substrat 1.

En particulier lorsque cette partie est une masse mobile intervenant dans une mesure de la jauge, et en particulier pour la masse mobile 2 ou le plot 12 s'il n'est pas ancré au substrat, on assure de préférence une isolation électrique de l'élément 5 par rapport à cette partie ou, pour le moins, on s'assure que cette isolation électrique est effective par rapport à l'élément 3 au sein de la masse 2 ou du plot 12.

D'une manière générale, la partie du dispositif, à laquelle l'élément 5 est raccordé de sorte à évacuer les calories de l'élément piézorésistif 3, est reliée à cet élément 5 de sorte à ne pas perturber les caractéristiques électriques utiles au fonctionnement de la jauge.

L'élément dissipateur 5 peut possiblement évacuer la chaleur par une connexion physique qui présente avec ce dernier une résistance thermique plus faible que l'élément 3. Eventuellement, il dissipe aussi l'énergie avec les fluides environnants à la manière d'un radiateur micro-électronique en maximisant la surface d'échange avec l'environnement extérieure. C'est notamment pertinent si le système est plongé dans un fluide comme de l'huile.

Au moins dans une direction transversale X ou Z, l'élément dissipateur thermique 5 présente une dimension supérieure à celle de l'élément piézorésistif 3.

Comme le montre la figure 6B, l'élément 5 a une direction d'extension principale dirigée suivant X. Au niveau de la portion de raccordement de l'élément piézorésistif 3 avec l'élément dissipateur thermique 5, on constate un virage révélant un changement de direction de la matière à cet endroit. L'élément 5 y présente donc une dimension principale (ici x) qui est oblique, et de préférence perpendiculaire à la direction longue de l'élément 3.

De préférence, le raccordement entre l'élément dissipateur thermique 5 et le substrat s'effectue à une extrémité de l'élément 5 qui se trouve opposée à la portion de raccordement. En particulier, lorsque l'élément 5 présente une direction longitudinale suivant l'axe X, perpendiculaire à l'axe Y de la jauge, la zone dans laquelle il est raccordé au substrat peut être la zone située la plus éloignée de l'élément piézorésistif 3.

On peut utiliser une modalité de raccordement, pour l'élément 5, semblable à ce qui a été décrit pour le raccordement de l'extrémité 31, par l'intermédiaire d'une partie 13, de préférence électriquement isolante, par exemple en oxyde, typiquement de l'oxyde de silicium. Lors de la fabrication, la couche utilisée pour former ces deux parties 11,13 peut-être commune.

De préférence, la conduction thermique au travers de la partie 13 est importante de sorte à maximiser la dissipation de chaleur opérée par l'élément 5. À cet effet, il est avantageux que la partie 13 soit dans un matériau présentant un bon niveau de conductivité thermique et/ou de bonnes conditions géométriques de conduction thermique, de sorte à disposer d'une conductance thermique importante, par exemple du même ordre que celle de l'élément de dissipation thermique 5.

Dans le cas représenté à la figure 6B, la section de la partie 13 est inférieure à celle du bloc 52 formant l'extrémité distale de l'élément 5. Cependant, ce cas n'est pas limitatif et on peut notamment chercher à ce qu'une plus grande surface, voire la totalité de la surface inférieure du bloc 52, soit reliée à la partie 13.

Dans l'exemple de cette figure, l'élément dissipateur thermique comporte un bras 51 relié à l'élément piézorésistif 3 (le terme bras est ici employé pour une portion allongée, de section constante ou non, suivant une direction longitudinale et qui présente, suivant cette direction, une raideur bien supérieure -par exemple au moins dix fois supérieure- à la raideur constatée dans au moins une direction transversale à la direction longitudinale, cette au moins une direction transversale pouvant correspondre à la direction de détection de la jauge, à savoir la dimension longue de l'élément piézorésistif 3) ; ces deux parties forment ici un angle droit et disposent de comportements de poutres mécaniques similaires, mais décalés angulairement de 90°. En particulier, la raideur du bras 51 est la plus faible suivant la direction de détection Y alors qu'elle y est maximale pour l'élément 3. Cette disposition limite l'influence mécanique de l'élément dissipateur 5 sur le reste de la jauge.

D'une manière générale, il est avantageux que l'élément dissipateur 5 présente une portion allongée correspondant au bras 51 dans la figure 6B, de sorte à réduire la raideur de l'élément 5 dans une direction privilégiée, à savoir la direction de détection de la jauge, ici l'axe Y.

Il est souhaitable que la raideur transverse selon Y de l'élément 5 (par exemple ici l'ensemble 51 et 52) par rapport au substrat soit faible devant la raideur de l'élément 3, dans la direction de détection (ici Y).

Dans le cas où les ancrages 31 et 32 sont eux même mobiles, il est en outre souhaitable que la raideur selon Y de l'élément 5 (ici l'ensemble 51-52) par rapport au substrat 1 (en l'absence de connexion avec la jauge 3) soit plus faible que la raideur de 31 ou 32 par rapport au substrat en l'absence de la connexion avec l'élément 5.

Dans l'exemple de la figure 6A, le bras 51 est directement relié à la portion de raccordement de l'élément piézorésistif 3, mais d'autres configurations sont possibles comme le montreront les illustrations suivantes.

Dans cette représentation, l'élément dissipateur thermique 5 s'étend latéralement depuis le milieu de la longueur de l'élément piézorésistif 3, de sorte que ce dernier se retrouve divisé en deux demi poutres présentant chacune une raideur double de celle (ici appelée $k_p$) qu'aurait isolément la poutre formant l'élément piézorésistif 3. Dans ces conditions, l'accroissement de la raideur de la jauge dans la direction Y de détection telle que produite par l'élément dissipateur thermique 5 peut rester faible et obéit environ à la formule ci-après : $(1+k_b/2k_p)(1+k_b/4k_p)$ où $k_b$ est la raideur de l'élément dissipateur thermique 5 selon Y.

On donne ci-après un exemple de sélection dimensionnelle :

Le bras est une poutre simple de facteur de forme $r_b = \frac{w_b}{L_b}$ et d'épaisseur $t_b$

Condition raideur : $k_p = \frac{ES_p}{L_p} \gg k_b = \frac{Et_b}{12} r_b^3$ , E étant le module d'Young.

Conditions conductivité thermique :

$$R_{thp} = \frac{\rho_{th} L_p}{w_p t_p} \gg R_{thb} = \frac{\rho_{th} L_b}{w_b t_b}$$

Pour une épaisseur de bras $t_b = t_p$ fixé, le facteur de forme de la poutre de refroidissement $r_b$ doit satisfaire :

$$u \ll r_b = \frac{w_b}{L_b} \ll \sqrt[3]{12u}$$

Avec $u = \frac{t_p w_p}{t_b L_p} = r_p$ le facteur de forme de la jauge

Application numérique pour une jauge de 0,25 x 0,25 x 5 $\mu m^3$.

Pour des raisons de simplicité de procédé de fabrication, l'utilisation d'un bras 51 de même épaisseur que la jauge peut être envisagée. On vérifie que les conditions peuvent être respectées :

- Si $t_b = t_p = 0.25\ \mu m : u = \frac{1}{20}$

- On a $0.05 \ll r_b = \frac{w_b}{L_b} \ll 0.84$

- Le facteur de forme rb = 0.2 peut convenir
- Par exemple, on peut prendre une largeur :

$w_b$ = 1 $\mu m$ : 1,2 $\mu m$ « $L_b$ « 20 $\mu m$ soit $L_b$ = 5 $\mu m$
$w_b$ = 2 $\mu m$ 2,4 $\mu m$ « $L_b$ « 40 $\mu m$ soit $L_b$ = 10 $\mu m$

La figure 6B révèle par ailleurs, de manière non limitative car le bras 51 peut être suffisant, que l'élément dissipateur thermique 5 se poursuit au-delà du bras 51 par un bloc 52 disposant d'au moins une dimension, transversale à la dimension longitudinale du bras 51, supérieure à la dimension correspondante dudit bras 51 ; en particulier, le bloc 52 peut présenter un élargissement suivant la direction Y, par exemple avec une dimension deux à trois fois supérieure à celle du bras 51 dans cette direction.

L'élément 5, notamment à son extrémité distale, est relié au substrat. Par exemple, le bloc 52 peut être ancré sur la face du substrat 1 par la partie 13 précédemment décrite. Dans cette configuration, l'élément 5 comporte une partie de faible raideur par le bras 51 et une partie plus massive par le bloc 52 pour un raccordement au substrat optimisant la conduction thermique vers ce dernier.

Toujours dans le mode de réalisation des figures 6A et 6B, la dimension en hauteur de l'élément dissipateur thermique 5 est fixe. Par ailleurs, cette dimension correspond à celle de l'élément piézorésistif 3. Le mode de réalisation dans lequel la hauteur de l'élément piézorésistif 3 et la hauteur de l'élément dissipateur thermique 5 sont égales, comme illustré à la figure 6A, n'est pas couvert par les revendications.

D'une manière générale et dans tous les modes de réalisation, dans la direction X, le bras 51 peut par exemple avoir une dimension d'au moins 1 $\mu$m, et de préférence d'au moins 3 $\mu$m. L'ensemble de l'élément dissipateur 5 peut présenter une longueur plus importante, et par exemple d'au moins 5 $\mu$m, voire au moins 10 $\mu$m, et de préférence plus de 20 $\mu$m. Suivant la direction Y, sa dimension est de préférence inférieure ou égale à 5 $\mu$m, voire à 2 $\mu$m, et de préférence inférieure ou égale à 1 $\mu$m.

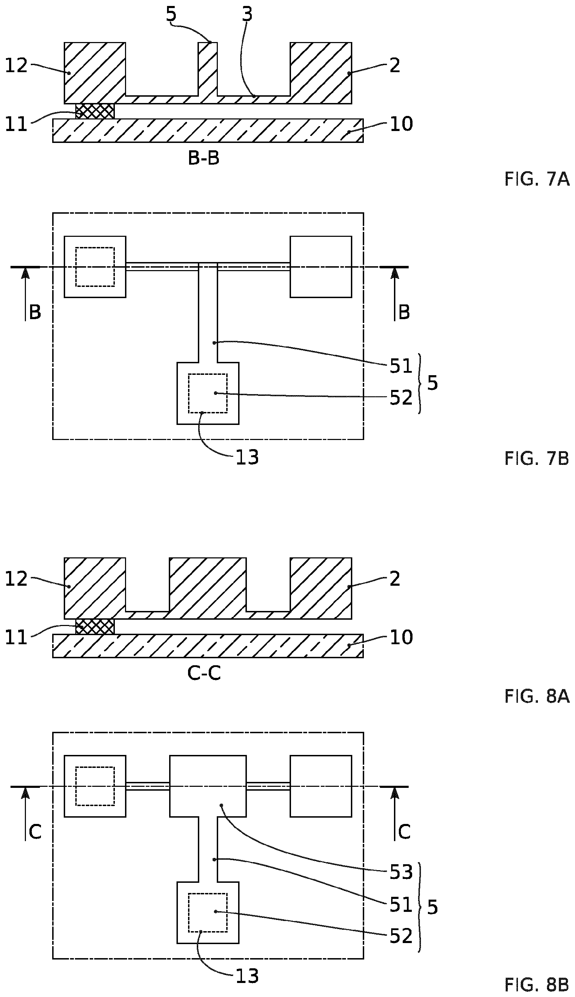

Le mode de réalisation présenté aux figures 7A et 7B est assez proche du précédent, sauf en ce que la dimension en hauteur, suivant Z, de l'élément dissipateur thermique 5 est plus importante que celle de l'élément piézorésistif 3. Par exemple, cette épaisseur pourra correspondre à celle du plot d'ancrage 12 du dispositif de détection. Il peut s'agir d'une épaisseur de plus de 1 μm, et par exemple de 20 μm. La hauteur suivant Z de l'élément dissipateur thermique 5 est typiquement au moins deux fois, de préférence au moins cinq fois, supérieure à la hauteur selon Z de l'élément piézorésistif. Dans la disposition illustrée, l'élément 5 fait ainsi nettement saillie au-dessus de l'élément piézorésistif 3.

Cette configuration augmente significativement l'efficacité thermique de l'élément 5 sans pour autant pénaliser la raideur. Cela permet de réduire le rapport de forme entre la largeur du bras 51 suivant Y et la longueur du bras 51 suivant X, par exemple à une valeur de 1/25. Notamment, en prenant une largeur de bras 51 de 1 μm, la longueur du bras peut être choisie à partir de 25 μm, et par exemple entre 25 et 50 μm. Avantageusement, la condition sur la résistance thermique du bras et sur sa raideur est plus simple et ouvre un espace de dimensionnement plus important en ajoutant un degré de liberté supplémentaire pour le dimensionnement du bras. Par exemple, il est possible de maintenir la conductance thermique constante à un niveau bas en augmentant l'épaisseur et en réduisant le rapport de forme dans des proportions inverses. Une baisse significative de la raideur transverse peut ainsi être avantageusement obtenue ainsi l'épaisseur de la pièce 5 en lien avec le rapport de forme sont deux paramètres qui permettent d'ajuster les conditions de raideur et de de résistance thermique pour répondre aux besoins de l'invention.

Comme précédemment, une partie 13 du substrat 1 est raccordée à l'élément dissipateur 5 pour évacuer des calories.

Par exemple, pour la jauge type de longueur 5 μm, le passage à une structure de 2 x 2.5 μm permet de doubler le SNR :

- En assurant un courant de polarisation limite de $I_0$ = 800 μA
- Une température d'échauffement maximum (au milieu de la jauge, ici sous forme de poutres) étant sensiblement identique à la situation sans bras de refroidissement.
- En pratique, pour $L_b$ = 25 μm, $tb$ = 20 μm et $w_b$ = 1 μm, on a : $k_b \approx \frac{k_p}{10}$ et

$$R_{thb} = \frac{R_{thp}}{64}$$

- La fréquence de résonance des poutres décrites ici est a priori supérieure à quelques centaines de kHz, soit $f_r$ » $f_r$ MEMS,
- $f_r$ MEMS de l'ordre de 10 kHz typiquement pour des accéléromètres, des gyromètres. Les dimensions du bras sont à adapter en fonction du MEMS pour respecter la condition sur la fréquence de résonance.

Dans le cas des figures 8A et 8B, la partie de l'élément dissipateur thermique 5 associée à la portion de raccordement de l'élément piézorésistif 3 est un deuxième bloc 53 ; dans cette configuration, l'élément 5 dispose, au niveau de la portion de raccordement, d'une dimension suivant la direction Y qui est plus importante que précédemment, et qui peut être d'au moins un, voire de plusieurs micromètres. De plus, le bloc 53 peut s'étendre suivant la direction X de part et d'autre de l'élément piézorésistif 3. Il peut typiquement être un bloc superposé à l'élément 3. On comprend que la présence d'une portion plus massive de l'élément dissipateur thermique à l'endroit de la portion de raccordement avec l'élément piézorésistif est favorable au refroidissement de ce dernier, dans la mesure où la zone d'échanges thermiques est plus importante et où l'élément dissipateur est plus massif pour absorber l'échauffement.

Comme dans les cas précédents, l'autre extrémité de l'élément 5 est raccordée au substrat 1, par une partie 13 de ce dernier.

Comme précédemment, la limitation de raideur de l'élément dissipateur thermique 5 suivant Y est produite par la présence d'un bras 51 de plus faible dimension suivant Y.

D'un point de vue électrique, la modification de résistance sera d'autant plus négligeable que l'épaisseur du bloc 53 central sera grande. La résistance du bloc 53 aura tendance à diminuer lorsque les dimensions latérales (non parallèles à la direction de détection Y de la jauge) augmentent (dans l'hypothèse où la résistivité électrique est constante dans l'élément 5).

D'un point de vue mécanique, l'influence du bloc 53 central est d'autant plus réduite lorsque $k_b$ << $k_n$ (raideur de la jauge suivant Y). La présence du bloc 53 aura tendance à diminuer la fréquence de résonance de l'élément 5 en particulier pour des tailles importantes (notamment > 10μm).

En revanche, les conditions sur les autres caractéristiques mécaniques peuvent être et sont a priori différentes en ce qui concerne la réponse en déformation selon les autres axes et en rotation. Le système proposé peut avantageusement être utilisé pour réduire la limite de fonctionnement en compression des jauges. Pour une longueur d'élément 3 et des conditions d'ancrages données, il apparait une valeur limite de contrainte en compression, au-delà de laquelle on a le phénomène de flambage de la poutre. En subdivisant la jauge en deux ou plusieurs parties, il est possible de repousser cette limite. Ceci peut être réalisé de manière optimale en s'assurant que les autres paramètres de raideurs autres que $k_b$ soient importants (les degrés de liberté du bloc 53 autres que le déplacement selon Y sont idéalement bloqués).

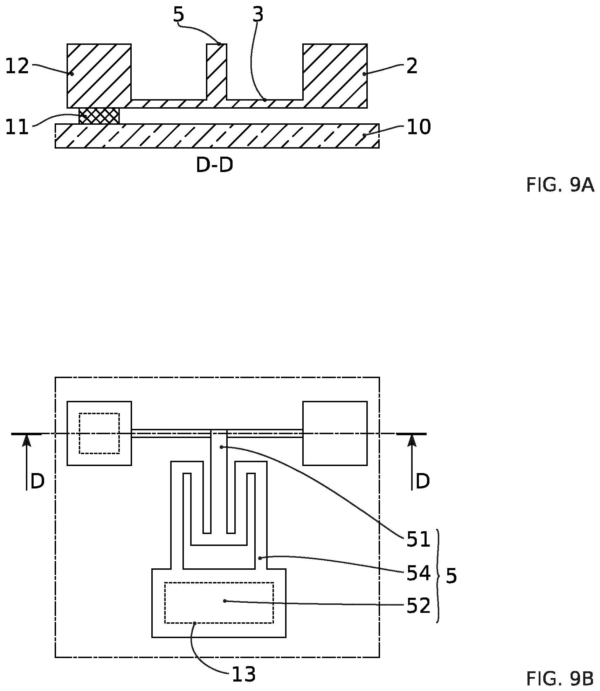

Les figures 9A et 9B fournissent une autre variante de réalisation dans laquelle l'élément dissipateur thermique 5 est muni d'un organe ressort 54 s'étendant au-delà d'un bras 51. Cet organe 54 permet d'accroître l'extension globale de l'élément dissipateur thermique 5 sans pour autant que sa dimension suivant l'axe X (ou Z) soit trop pénalisante. Il peut être réalisé par une forme repliée suivant la direction Y et/ou suivant la direction Z. Il présente avantageusement plusieurs portions s'étendant chacune principalement selon la direction X ou la direction Y et raccordées les unes aux autres. Avantageusement, les différentes portions de l'organe ressort 54 sont raccordées de façon à former deux à deux des structures en coude dans le plan XY. Comme dans les modes de réalisation précédents, l'illustration montre un élément dissipateur 5 raccordé au substrat 1. Ainsi, une extrémité distale de l'organe ressort 54 est ancrée au substrat 1 par une partie 13 de ce dernier. Dans cette configuration, l'organe 54 favorise par ailleurs une limitation de la raideur de l'élément 5.

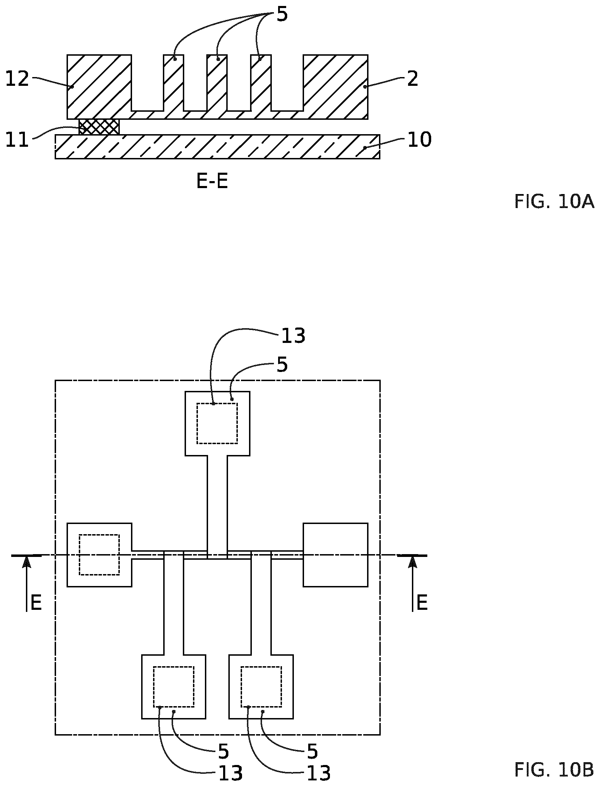

Suivant les figures 10A et 10B, trois éléments dissipateurs thermiques 5 sont répartis suivants la dimension longue de l'élément piézorésistif 3. Un premier élément dissipateur 5 est positionné au milieu de la longueur de l'élément piézorésistif 3. Les deux autres éléments 5 sont répartis de part et d'autre du premier, avantageusement de manière symétrique. D'une manière générale, dans le cas d'une pluralité d'éléments dissipateurs thermiques 5, il est avantageux qu'ils soient répartis de manière symétrique relativement au milieu de l'élément piézorésistif et répartis de manière homogène sur l'ensemble de la poutre de déformation. Comme représenté, on peut par ailleurs alterner le côté de déport des éléments dissipateurs thermiques, de part et d'autre de l'élément piézorésistif 3.

Ainsi, dans cette disposition, les éléments dissipateurs thermiques 5 sont disposés en quinconce et délimitent quatre tronçons, de préférence de longueur égale, sur la longueur de l'élément piézorésistif 3. La limite de courant peut être augmentée d'un rapport 4 tout comme le rapport signal bruit peut être augmenté d'un rapport 4 avec le même échauffement dans l'élément piézorésistif 3. Pour assurer une isolation électrique entre les dissipateurs, il est avantageux que chacun des éléments dissipateurs 5 soit individuellement raccordé au substrat, par une partie 13, assurant une conduction thermique.

L'invention n'est pas limitée aux modes de réalisations précédemment décrits et s'étend à tous les modes de réalisation couverts par les revendications. La présente invention ne se limite pas aux exemples précédemment décrits. Bien d'autres variantes de réalisation sont possibles, par exemple par combinaison de caractéristiques précédemment décrites. En outre, les caractéristiques décrites relativement à un aspect de l'invention peuvent être combinées à un autre aspect de l'invention. Par exemple, la formation d'un bloc 52 ou 53 peut parfaitement se présenter dans les exemples des figures 9A à 10B.

## Revendications

1. Dispositif de détection à transduction, comprenant un substrat (1), au moins une masse mobile (2) relativement au substrat (1) et une jauge de contrainte suspendue dotée d'un élément piézorésistif (3) qui comprend un premier ancrage (31) relativement à une portion d'ancrage et un deuxième ancrage (32), différent du premier ancrage (31), relativement à la masse mobile (2), le dispositif comprenant au moins un élément dissipateur thermique (5) raccordé de manière thermiquement conductrice, d'une part à une portion de raccordement de l'élément piézorésistif (3) située en dehors des ancrages (31, 32), et d'autre part à une partie d'évacuation thermique du dispositif autre que l'élément piézorésistif (3), ledit élément dissipateur thermique (5) comprenant un bras (51) s'étendant selon une direction longitudinale et présentant, suivant une direction perpendiculaire à sa dimension longitudinale et à la direction de détection, une dimension en hauteur supérieure à une dimension en hauteur de l'élément piézorésistif (3), l'élément dissipateur thermique (5) présentant, au niveau de la portion de raccordement, une direction principale oblique relativement à une dimension longue de l'élément piézorésistif (3), **caractérisé en ce que** le rapport entre la dimension en hauteur de l'élément dissipateur thermique (5) et une dimension en hauteur de l'élément piézorésistif (3) étant supérieur à 2, de préférence supérieur à 5.

2. Dispositif selon la revendication précédente, dans lequel l'élément piézorésistif (3) est parcouru par un courant électrique entre le premier ancrage (31) et le deuxième ancrage (32) lorsque ledit dispositif est en fonctionnement.

3. Dispositif selon l'une quelconque des revendications précédentes, dans lequel la partie d'évacuation thermique est l'un parmi le substrat (1), la masse mobile (2), la portion d'ancrage du premier ancrage (31).

4. Dispositif selon l'une quelconque des revendications précédentes, dans lequel la portion d'ancrage est une portion du substrat (1), et dans lequel l'élément piézorésistif (3) comporte une première raideur, suivant une direction de détection (Y) dans laquelle l'élément piézorésistif (3) est sollicité en traction ou en compression, et dans lequel l'élément dissipateur thermique (5) présente, suivant la direction de détection, une deuxième raideur qui est strictement inférieure à la première raideur.

5. Dispositif selon l'une quelconque des revendications précédentes, dans lequel l'élément dissipateur thermique (5) comprend une partie suspendue s'étendant depuis la portion de raccordement.

**6.** Dispositif selon l'une quelconque des revendications précédentes, dans lequel la dimension longitudinale du bras (51) est dirigée obliquement relativement à la direction de détection.

**7.** Dispositif selon la revendication précédente, dans lequel la dimension longitudinale est perpendiculaire à la direction de détection.

**8.** Dispositif selon l'une quelconque des deux revendications précédentes, dans lequel le bras (51) présente un rapport de forme de la dimension longitudinale et sa dimension suivant la direction de détection d'au moins 5.

**9.** Dispositif selon l'une quelconque des revendications précédentes, dans lequel l'élément dissipateur thermique (5) présente une conductance thermique supérieure ou égale à celle de l'élément piézorésistif (3), et de préférence au moins dix fois supérieure.

**10.** Dispositif selon l'une quelconque des revendications précédentes, dans lequel l'élément dissipateur thermique (5) présente au moins un degré de liberté de mouvement relativement à la partie d'évacuation thermique.

**11.** Dispositif selon l'une quelconque des revendications précédentes, dans lequel l'élément dissipateur thermique (5) comporte un organe ressort (54).

**12.** Dispositif selon l'une quelconque des revendications précédentes, dans lequel l'élément dissipateur thermique (5) comporte une fréquence de résonance strictement supérieure à celle d'un ensemble formé par la jauge et la masse mobile (2), et de préférence au moins 5 fois, voire 10 fois supérieure.

**13.** Dispositif selon l'une quelconque des revendications précédentes, comprenant plusieurs éléments dissipateurs thermiques (5).

**14.** Dispositif selon la revendication précédente, dans lequel les éléments dissipateurs thermiques (5) sont chacun raccordé à une portion de raccordement de l'élément piézorésistif (3), les portions de raccordement découpant l'élément piézorésistif (3) en tronçons de longueur identique suivant la dimension longue de l'élément piézorésistif (3).

**15.** Dispositif selon l'une quelconque des deux revendications précédentes, dans lequel les éléments dissipateurs thermiques (5) sont disposés de part et d'autre de la dimension longue de l'élément piézorésistif (3) de manière alternée.

**Patentansprüche**

**1.** Detektionsvorrichtung mit Transduktion, umfassend ein Substrat (1), mindestens eine bezüglich des Substrats (1) bewegliche Masse (2) sowie einen aufgehängten Dehnungsmesser, der mit einem piezoresistiven Element (3) versehen ist, das eine erste Verankerung (31) bezüglich eines Verankerungsabschnitts umfasst, und eine zweite Verankerung (32), die sich von der ersten Verankerung (31) unterscheidet, bezüglich der beweglichen Masse (2), wobei die Vorrichtung mindestens ein Wärmeableitungselement (5) umfasst, das thermisch leitfähig einerseits an einem Anschlussabschnitt des piezoresistiven Elements (3), der sich außerhalb der Verankerungen (31, 32) befindet, und andererseits an einem Wärmeableitungsteil der anderen Vorrichtung als dem piezoresistiven Element (3) befindet, angeschlossen ist, wobei das Wärmeableitungselement (5) einen Arm (51) umfasst, der sich entlang einer Längsrichtung erstreckt und entlang einer Richtung senkrecht zu seiner Längsabmessung und zu der Erfassungsrichtung eine Höhenabmessung aufweist, die größer ist als eine Höhenabmessung des piezoresistiven Elements (3), wobei das Wärmeableitungselement (5) im Bereich des Anschlussabschnitts eine Hauptrichtung schräg bezüglich einer Längsabmessung des piezoresistiven Elements (3) aufweist, **dadurch gekennzeichnet, dass** das Verhältnis zwischen der Höhenabmessung des Wärmeableitungselements (5) und einer Höhenabmessung des piezoresistiven Elements (3) größer ist als 2, bevorzugt größer als 5.

**2.** Vorrichtung nach dem vorstehenden Anspruch, wobei das piezoresistive Element (3) von einem elektrischen Strom zwischen der ersten Verankerung (31) und der zweiten Verankerung (32) durchlaufen wird, wenn die Vorrichtung in Betrieb ist.

**3.** Vorrichtung nach einem der vorstehenden Ansprüche, wobei der Wärmeableitungsteil eines des Substrats (1), der beweglichen Masse (2), des Verankerungsabschnitts der ersten Verankerung (31) ist.

**4.** Vorrichtung nach einem der vorstehenden Ansprüche, wobei der Verankerungsabschnitt ein Abschnitt des Substrats (1) ist, und wobei das piezoresistive Element (3) eine erste Steifigkeit entlang einer Erfassungsrichtung (Y), in der das piezoresistive Element (3) zug- oder kompressionsbeansprucht ist, umfasst, und wobei das Wärmeableitungselement (5) entlang der Erfassungsrichtung eine zweite Steifigkeit aufweist, die strikt kleiner ist als die erste Steifigkeit.

**5.** Vorrichtung nach einem der vorstehenden Ansprüche, wobei das Wärmeableitungselement (5) einen aufgehängten Teil, der sich von dem Anschlussabschnitt aus erstreckt, umfasst.

6. Vorrichtung nach einem der vorstehenden Ansprüche, wobei die Längsabmessung des Arms (51) schräg relativ zu der Erfassungsrichtung ausgerichtet ist.

7. Vorrichtung nach dem vorstehenden Anspruch, wobei die Längsabmessung senkrecht zu der Erfassungsrichtung steht.

8. Vorrichtung nach einem der beiden vorstehenden Ansprüche, wobei der Arm (51) ein Formverhältnis der Längsabmessung und seiner Abmessung entlang der Erfassungsrichtung von mindestens 5 aufweist.

9. Vorrichtung nach einem der vorstehenden Ansprüche, wobei das Wärmeableitungselement (5) eine Wärmeleitfähigkeit größer oder gleich der des piezoresistiven Elements (3) und bevorzugt mindestens zehn Mal größer aufweist.

10. Vorrichtung nach einem der vorstehenden Ansprüche, wobei das Wärmeableitungselement (5) mindestens einen Bewegungsfreiheitsgrad bezüglich des Wärmeableitungsteils umfasst.

11. Vorrichtung nach einem der vorstehenden Ansprüche, wobei das Wärmeableitungselement (5) ein Federorgan (54) umfasst.

12. Vorrichtung nach einem der vorstehenden Ansprüche, wobei das Wärmeableitungselement (5) eine Resonanzfrequenz strikt größer oder gleich der einer Anordnung umfasst, die aus dem Messgerät und der beweglichen Masse (2) gebildet ist, und bevorzugt mindestens 5 Mal, ja sogar 10 Mal größer.

13. Vorrichtung nach einem der vorstehenden Ansprüche, die mehrere Wärmeableitungselemente (5) umfasst.

14. Vorrichtung nach dem vorstehenden Anspruch, wobei die Wärmeableitungselemente (5) jeweils an einen Anschlussabschnitt des piezoresistiven Elements (3) angeschlossen sind, wobei die Anschlussabschnitte das piezoresistive Element (3) in Stücke mit identischer Länge entlang der Längsabmessung des piezoresistiven Elements (3) schneiden.

15. Vorrichtung nach einem der beiden vorstehenden Ansprüche, wobei die Wärmeableitungselemente (5) zu beiden Seiten der Längsabmessung des piezoresistiven Elements (3) abwechselnd angeordnet sind.

## Claims

1. Transduction detection device, comprising a substrate (1), at least one movable mass (2) relative to the substrate (1) and a suspended stress gauge provided with a piezoresistive element (3) which comprises a first anchoring (31) relative to an anchoring portion and a second anchoring (32), different from the first anchoring (31), relative to the movable mass (2), **characterised in that** it comprises at least one thermal dissipator element (5) thermally conductively connected, on the one hand to a connection portion of the piezoresistive element (3) located outside of the anchorings (31, 32), and on the other hand, to a thermal discharge part of the device, other than the piezoresistive element (3), and **in that** said thermal dissipator element (5) comprises an arm (51) extending in a longitudinal direction and having, in a direction perpendicular to its longitudinal dimension and to the detection direction, a dimension by height greater than a dimension by height of the piezoresistive element (3), the thermal dissipator element (5) having, at the connection portion, a main direction oblique relative to a long dimension of the piezoresistive element (3), **characterised in that** the ratio between the dimension by height of the thermal dissipator element (5) and a dimension by height of the piezoresistive element (3) being greater than 2, preferably greater than 5.

2. Device according to the preceding claim, wherein the piezoresistive element (3) is crossed by an electrical current between the first anchoring (31) and the second anchoring (32) when said device is in operation.

3. Device according to any one of the preceding claims, wherein the thermal discharge part is one from among the substrate (1), the movable mass (2), the anchoring portion of the first anchoring (31).

4. Device according to any one of the preceding claims, wherein the anchoring portion is a portion of the substrate (1), and wherein the piezoresistive element (3) comprises a first rigidity, in a detection direction (Y), wherein the piezoresistive element (3) is urged in traction or in compression, and wherein the thermal dissipator element (5) has, in the detection direction, a second rigidity which is strictly less than the first rigidity.

5. Device according to any one of the preceding claims, wherein the thermal dissipator element (5) comprises a suspended part extending from the connection portion.

6. Device according to any one of the preceding claims, wherein the longitudinal dimension of the arm (51) is directly obliquely relative to the detection direction.

7. Device according to the preceding claim, wherein the longitudinal dimension is perpendicular to the detection direction.

8. Device according to any one of the two preceding claims, wherein the arm (51) has a shape ratio of the longitudinal dimension and its dimension in the detection direction of at least 5.

9. Device according to any one of the preceding claims, wherein the thermal dissipator element (5) has a thermal conductance greater than or equal to that of the piezoresistive element (3), and preferably at least ten times greater.

10. Device according to any one of the preceding claims, wherein the thermal dissipator element (5) has at least one degree of freedom of movement relative to the thermal discharge part.

11. Device according to any one of the preceding claims, wherein the thermal dissipator element (5) comprises a spring member (54).

12. Device according to any one of the preceding claims, wherein the thermal dissipator element (5) comprises a resonance frequency strictly greater than that of an assembly formed by the gauge and the movable mass (2), and preferably at least 5 times, even 10 times greater.

13. Device according to any one of the preceding claims, comprising several thermal dissipator elements (5).

14. Device according to the preceding claim, wherein the thermal dissipator elements (5) are each connected to a connection portion of the piezoresistive element (3), the connection portions cutting the piezoresistive element (3) into sections of identical length along the long dimension of the piezoresistive element (3).

15. Device according to any one of the two preceding claims, wherein the thermal dissipator elements (5) are disposed on either side of the long dimension of the piezoresistive element (3), alternately.

FIG. 1

Détail A

FIG. 2

FIG. 3

FIG. 4

FIG. 5

A-A

FIG. 6A

FIG. 6B

B-B

FIG. 7A

FIG. 7B

C-C

FIG. 8A

FIG. 8B

FIG. 9A

FIG. 9B

12 — 5 — 2

11 — 10

E-E

FIG. 10A

13

5

E — E

5 — 13

5 — 13

FIG. 10B

**RÉFÉRENCES CITÉES DANS LA DESCRIPTION**

**Documents brevets cités dans la description**

- US 2017113918 A1
- EP 3339242 A1